# EUROPÄISCHE PATENTSCHRIFT

(11) **EP 1 777 817 B1**
(45) Veröffentlichungstag und Bekanntmachung des Hinweises auf die Patenterteilung: **19.07.2017**
(21) Anmeldenummer: 06015234.5
(22) Anmeldetag: 21.07.2006
(51) Int. Cl.: H03H 17/02

(54) **Digitales Filter mit starrem Filterzustand während ungültiger Signalbereiche in einer digitalen Filterkaskade**
Digital filter with stable filter state during invalid signal regions in a digital filter cascade
Filtre numérique ayant un état stable pendant les régions ou la signal est invalide dans une cascade de filtres numériques

(30) Priorität: 20.10.2005 DE 102005050307
(43) Veröffentlichungstag der Anmeldung: 25.04.2007
(73) Patentinhaber: Rohde & Schwarz GmbH & Co. KG, 81671 München (DE)
(72) Erfinder: Nitsch, Bernhard, Dr., 81825 München (DE); Schmidt, Kurt, Dr., 85567 Grafing (DE); Renardy, Paul, 81927 München (DE)
(74) Vertreter: Körfer, Thomas

(56) Entgegenhaltungen:
- EP-A- 1 271 778
- EP-A- 1 372 264
- US-A- 4 800 431
- US-B1- 6 857 002
- CHU S ET AL: "Optimum FIR and IIR Multistage Multirate Filter Design" CIRCUITS, SYSTEMS AND SIGNAL PROCESSING, CAMBRIDGE, MS, US, Bd. 2, Nr. 3, 1983, Seiten 361-386, XP002409259 ISSN: 0278-081X

## Beschreibung

Die Erfindung betrifft ein digitales Filter mit starrem ("eingefrorenem") Filterzustand während ungültiger Signalbereiche in einer digitalen Filterkaskade.

Digitale Signalverarbeitungsstrecken, wie sie beispielsweise in Spektrumanalysatoren zum Einsatz kommen, enthalten eine digitale Filterkaskade aus mehreren seriell verschalteten digitalen Filtern, die eine für ihre jeweilige Funktion sinnvolle Filterstruktur aufweisen.

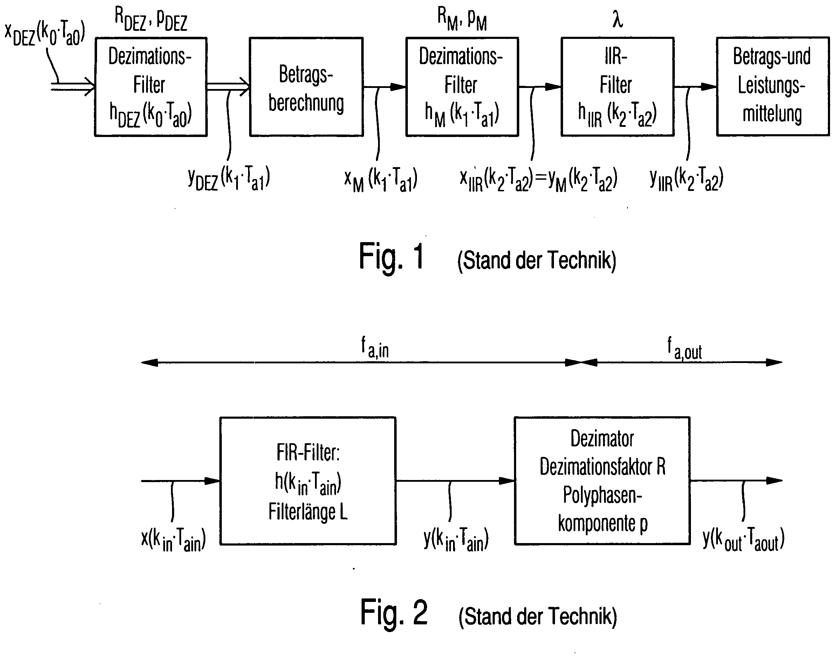

Fig. 1 zeigt eine derartige digitale Filterkaskade für den Empfangskanal eines Spektrumanalysators. Am Eingang dieser digitalen Filterkaskade liegt das empfangene komplexwertige Basisbandsignal mit der hohen Abtastfrequenz an, das in einem ersten dezimierenden Filter F_{DEZ}'- mit der Impulsantwort h_{DEZ}(k₀·Tₐ₀), der Filterlänge L_{DEZ}, dem Dezimationsfaktor R_{DEZ} und der Polyphasenkomponente p_{DEZ} - in ein Ausgangssignal y_{DEZ}(k₁·Tₐ₁) mit einer niedrigeren Abtastfrequenz fₐ₁ gewandelt wird und anschließend einer Betragsbildung zugeführt wird. Das Betragsignal x_{M}(k₁·Tₐ₁) wird in einem zweiten dezimierenden Filter F_{M}'- mit der Impulsantwort h_{M}(k₁·Tₐ₁), der Filterlänge L_{M}, dem Dezimationsfaktor R_{M} und der Polyphasenkomponente p_{M} - geglättet und in ein Ausgangssignal y_{M}(k₂·Tₐ₂) mit einer gegenüber der niedrigeren Abtastfrequenz fₐ₁ zusätzlich reduzierten Abtastfrequenz fₐ₂ übergeführt. Auftretende Störsignalanteile des im zweiten dezimierenden Filter F_{M}' erzeugten Ausgangssignal y_{M}(k₂·Tₐ₂) werden in einem nachfolgenden Infinite-Impulse-Response-Filters (IIR-Filter) F_{IIR} mit der Impulsantwort h_{IIR}(k₂·Tₐ₂) und dem Gedächtnisfaktor λ unterdrückt. Das Ausgangssignal y_{IIR}(k₂·Tₐ₂) des IIR-Filters F_{IIR} wird schließlich am Ende der digitalen Filterkaskade einer Betrags- und/oder Leistungsmittelung unterworfen.

In der Spektrumanalyse darf z. B. eine Messung im Block "Betrags- Leistungsmittelung" nur erfolgen, wenn das Eingangssignal x_{DEZ}(k₀·Tₐ₀) der digitalen Filterkaskade gültig und eingeschwungen ist und alle digitalen Filter F_{DEZ}',F_{M}',F_{IIR} mit den Impulsantworten h_{DEZ}(k₀·Tₐ₀), h_{M}(k₁·Tₐ₁) und h_{IIR}(k₂·Tₐ₂) der digitalen Filterkaskade eingeschwungen sind. Im hier betrachteten Fall ist die Bandbreite der digitalen Filter F_{M}',F_{IIR} mit den Impulsantworten h_{M}(k₁·Tₐ₁) und h_{IIR}(k₂·Tₐ₂) deutlich kleiner als die Bandbreite des digitalen Filters F_{DEZ}' mit der Impulsantwort h_{DEZ}(k₂·Tₐ₂), so dass die Einschwingdauer der digitalen Filterkaskade bestehend aus den digitalen Filtern F_{M}',F_{IIR} mit den Impulsantworten h_{M}(k₁·Tₐ₁) und h_{IIR}(k₂·Tₐ₂) deutlich höher als die Einschwingdauer des digitalen Filters F_{DEz}' mit der Impulsantwort h_{IIR}(k₂·Tₐ₂) ist.

Werden in der Spektrumanalyse sogenannte "gegatete" Messungen durchgeführt, bei denen sich Signalabschnitte des Meßsignals mit gültigen Signalwerten mit Signalabschnitten des Meßsignals mit ungültigen Signalwerten abwechseln, so müssen alle digitalen Filter F_{DEZ}',F_{M}',F_{IIR} der digitalen. Filterkaskade mit jedem Beginn eines gültigen Signalabschnitts wieder von neuem einschwingen. Die lange Einschwingdauer der beiden digitalen Filter F_{M}',F_{IIR} mit den Impulsantworten h_{M}(k₁·Tₐ₁) und h_{IIR}(k₂·Tₐ₂) führt deshalb insbesondere bei "gegateten" Messungen nachteilig zu verhältnismäßig langen Meßzeiten. Dokument EP1271778 offenbart ein elektrisches Tiefpassfilter mit Sperrverhalten für eine vorbestimmte Sperrfrequenz, aufweisend eine Reihenschaltung mit einem FIR-Filter und einem IIR-Filter, wobei die Parameter des FIR-Filters im Wesentlichen auf das Sperrverhalten bei der Sperrfrequenz und die Parameter des IIR-Filters im Wesentlichen auf das Tiefpassverhalten abgestimmt sind.

Aufgabe der Erfindung ist es deshalb, die Meßzeit einer digitalen Filterkaskade mit mehreren digitalen Filtern, deren Bandbreiten beziehungsweise Einschwingzeiten jeweils in unterschiedlichen Größenbereichen liegen, insbesondere bei "gegateten" Messungen zu minimieren.

Die Aufgabe der Erfindung wird durch eine digitalen Filterkaskade mit den Merkmalen des Anspruchs 1 gelöst. Vorteilhafte Weiterentwicklungen der Erfindung sind in den abhängigen Ansprüchen aufgeführt.

Erfindungsgemäß werden die Filterzustände derjenigen digitalen Filter F_{M}',F_{IIR} der digitalen Filterkaskade, deren Bandbreiten jeweils vergleichsweise niedrig und deren Einschwingzeiten entsprechend lang sind, zu Beginn des jeweiligen ungültigen Signalabschnitts des jeweiligen Eingangssignal x_{M}(k₁·Tₐ₁),x_{IIR}(k₂·Tₐ₂) "eingefroren" und bleiben über die gesamte Dauer des jeweiligen ungültigen Signalabschnitts starr bzw. unverändert. Änderungen in den Eingangssignalen x_{M}(k₁·Tₐ₁),x_{IIR}(k₂·Tₐ₂) der jeweiligen digitalen Filter F_{M}',F_{IIR} aufgrund von Änderungen des empfangenen Meßsignals x_{DEZ}(k₀·Tₐ₀) am Eingang der digitalen Filterkaskade führen zu keiner Änderung der jeweiligen Filterzustände und damit zu einer Änderung in den Ausgangssignalen y_{M}(k₁·Tₐ₁),y_{IIR}(k₂·Tₐ₂) der jeweiligen digitalen Filter F_{M}',F_{IIR}. Unter der Voraussetzung, dass das Eingangssignal x_{M}(k₁·Tₐ₁),x_{IIR}(k₂·T₂ₐ) des jeweiligen digitalen Filters F_{M}',F_{IIR} am Beginn und am Ende der jeweiligen ungültigen Signalabschnitte näherungsweise identisch ist - näherungsweise stationäre Signalverhältnisse -, ist das jeweilige digitale Filter F_{M}',F_{IIR} am Beginn eines neuen gültigen Signalabschnitts bereits eingeschwungen. Die Einschwingzeit der gesamten digitalen Filterkaskade wird damit nur noch von der Einschwingdynamik derjenigen digitalen Filter F_{DEZ}' bestimmt, deren Filterzustände aufgrund deren vergleichsweiser hoher Bandbreite nicht "eingefroren" werden. Auf diese Weise wird die Einschwingzeit der gesamten digitalen Filterkaskade gegenüber einer digitalen Filterkaskade ohne "eingefrorene" Filterzustände der vergleichsweise "schnellen" digitalen Filter F_{DEZ}' reduziert.

Dem ersten digitalen Filter F_{DEZ}' der digitalen Filterkaskade wird ein Steuersignal x_{FSDEZ}(k₀·Tₐ₀) zugeführt, das ihm die Gültigkeit oder Nichtgültigkeit des aktuellen Signalabschnitts seines Eingangssignals x_{DEZ}(k₀·Tₐ₀) signalisiert. Auf der Basis dieses Steuersignals x_{FSDEZ}(k₀·Tₐ₀) und der Einschwingdynamik des ersten digitalen Filters F_{DEZ}' ermittelt eine zum ersten digitalen Filter F_{DEZ}' gehörige Einheit zur Steuersignal-Erzeugung St₀ ein Steuersignal Y_{FSDEZ}(k₁·Tₐ₁), das die Gültigkeit oder Nichtgültigkeit des aktuellen Signalabschnitts seines Ausgangssignals Y_{DEZ}(k₁·Tₐ₁) kennzeichnet und damit dem nachfolgenden digitalen Filter F_{M}' die Gültigkeit oder Nichtgültigkeit des aktuellen Signalabschnitts seines Eingangssignals x_{M}(k₁·Tₐ₁) signalisiert. Wird sukzessive für jedes nachfolgende digitale Filter über eine zugehörige Einheit zur Steuersignal-Erzeugung aus dem jeweils eingehenden Steuersignal und der Einschwingdynamik des zugehörigen digitalen Filters ein Steuersignal generiert, das die Gültigkeit oder Nichtgültigkeit des zum jeweils nachfolgenden digitalen Filter gehörigen Eingangssignals kennzeichnet, so kann auf diese Weise für jedes digitale Filter der digitalen Filterkaskade auf der Basis des empfangenen Steuersignals der Filterzustand am Beginn eines ungültigen Signalabschnitts des jeweiligen Eingangssignals zeitkorrekt angehalten und über die gesamte Dauer des jeweiligen ungültigen Signalabschnitts festgehalten werden.

Ist das digitale Filter mit vergleichsweise niedriger Bandbreite als dezimierendes Filter ausgeführt, wie beispielsweise das dezimierende Filter F_{M}' mit der Impulsantwort h_{M}(k₁·Tₐ₁), so besteht es gemäß Fig. 2 aus einem nicht dezimierenden Filteranteil, das beispielsweise als FIR-Filter mit der Impulsantwort h(kᵢₙ·Tₐᵢₙ) und der Filterlänge L aus einem Eingangssignal x(kᵢₙ·Tₐᵢₙ) ein Ausgangssignal y(kᵢᵢₙ·Tₐᵢₙ) erzeugt, und einem Polyphasendezimator mit dem Dezimationsfaktor R und der Polyphasenkomponente p. Der Polyphasendezimator reduziert bekannterweise der Abtastfrequenz fₐᵢₙ seines Eingangssignals y(kᵢᵢₙ·Tₐᵢₙ) um den Dezimationsfaktor R auf die Abtastfrequenz fₐₒᵤₜ seines Ausgangssignals y(kᵢₒᵤₜ·Tₐₒᵤₜ) und erzeugt über die Polyphasenkomponente p ein Ausgangssignal y(kᵢₒᵤₜ·Tₐₒᵤₜ), das nach jedem i·R+p-ten Abtastzeitpunkt des Eingangssignals y(kᵢᵢₙ·Tₐᵢₙ) aktiviert ist. Hierzu verfügt der Polyphasendezimator über einen Polyhasenzähler, der mit der Abtastfrequenz fₐᵢₙ des Eingangssignals y(kᵢᵢₙ·Tₐᵢₙ) des Polyphasendezimators über die Länge des Dezimationsfaktors R inkrementiert und jeweils am Ausgang des Polyphasendezimators den zum selben Zeitpunkt am Eingang des Polyphasendezimators anliegenden Abtastwert ausgibt, wenn der Zählerstand des Polyhasenzählers den Wert der Polyphasenkomponente p erreicht. Dies wird dann zyklisch fortgesetzt.

Mit "Einfrieren" des Filterzustands des dezimierenden Filters während der Dauer des jeweiligen ungültigen Signalabschnitts ist auch der Zählerstand des Polyhasenzählers des zugehörigen Polyphasendezimators "einzufrieren", indem dieser Zählerstand in einem Polyphasenspeicher abgelegt wird und zu Beginn des nächsten gültigen Signalabschnitts wieder in den Polyhasenzähler geladen wird. Auf diese Weise arbeitet der Polyphasendezimator im Anschluss an den ungültigen Signalabschnitt phasenkorrekt wie im Falle eines Nichtauftretens des ungültigen Signalabschnitts weiter. Die phasenkorrekte Belegung des Polyhasenzählers des jeweiligen Polyphasendezimators zu Beginn des ersten gültigen Signalabschnitts erfolgt mit dem Wert 0, indem spätestens bis zu Beginn des ersten gültigen Signalabschnitts der Polyphasenspeicher mit dem Wert 0 initialisiert wird.

Ein Ausführungsbeispiel der erfindungsgemäßen digitalen Filterkaskade und des erfindungsgemäßen dezimierenden Filters werden im Folgenden unter Berücksichtigung der Zeichnung näher erläutert. In der Zeichnung zeigen:
- Fig. 1: ein Blockschaltbild einer digitalen Filterkaskade mit digitalen Einzelfiltern unterschiedlicher Bandbreite nach dem Stand der Technik,
- Fig. 2: ein Ersatzschaltbild eines dezimierenden Einzelfilters nach dem Stand der Technik,
- Fig. 3: ein Blockschaltbild einer erfindungsgemäßen digitalen Filterkaskade,
- Fig. 4: ein Zustandsdiagramm einer Einheit zur Steuersignal-Erzeugung und
- Fig. 5: ein Zeitdiagramm des Ausgangssignals eines erfindungsgemäßen dezimierenden Filters in Abhängigkeit des Steuersignals.

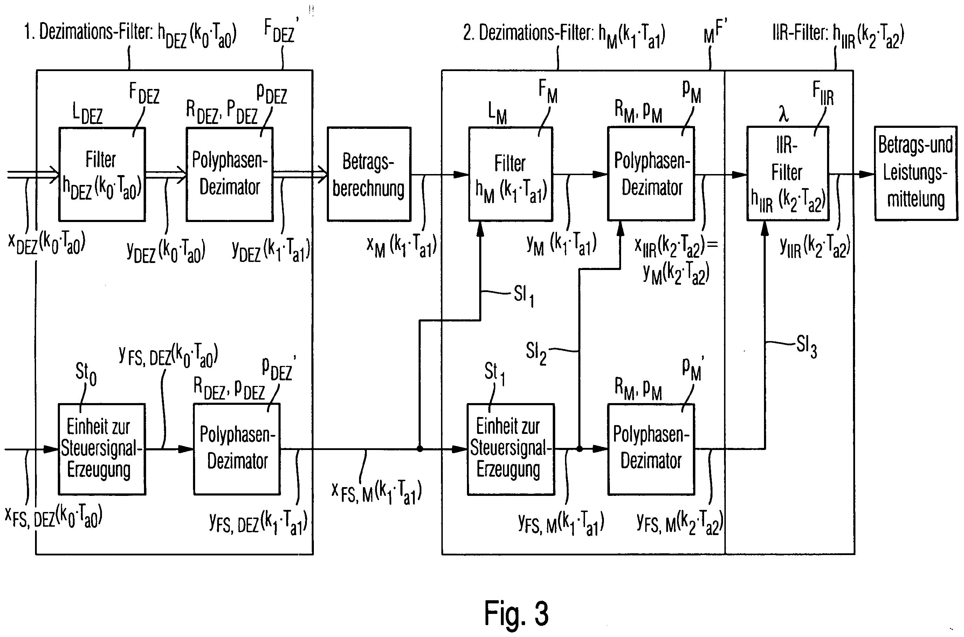

Im folgenden wird anhand von Fig. 3 die erfindungsgemäße digitalen Filterkaskade erläutert.

Ausgehend vom Blockschaltbild der digitalen Filterkaskade nach dem Stand der Technik in Fig. 1 wird das erste Dezimations-Filter F_{DEZ}' mit dem Eingangssignal x_{DEZ}(k₀·Tₐ₀) beaufschlagt. Das Eingangssignal x_{DEZ}(k₀·Tₐ₀) wird im nicht dezimierenden Filter F_{DEZ} des ersten Dezimations-Filter F_{DEZ}' mit der Impulsantwort h_{DEZ}(k₀·Tₐ₀) gefaltet und führt zu einem Ausgangssignal y_{DEZ}(k₀·Tₐ₀), das einen Einschwingvorgang von insgesamt L_{DEZ}-1 Abtastzeitpunkte seit Beginn der Anregung des nicht dezimierenden Filters F_{DEZ} mit dem Eingangssignal x_{DEZ}(k₀·Tₐ₀) aufweist, wobei L_{DEZ} die Filterlänge des FIR-Filters ist. Das Ausgangssignal y_{DEZ}(k₀·Tₐ₀) wird in einem Polyphasen-Dezimator P_{DEZ} in ein Ausgangssignal y_{DEZ}(k₁·Tₐ₁) gewandelt, das eine um den Dezimationsfaktor R_{DEZ} reduzierte Abtastfrequenz fₐ₁ gegenüber der Abtastfrequenz fₐ₀ des Eingangssignals x_{DEZ}(k₀·Tₐ₀) aufweist und nach jedem i·R_{DEZ}+p_{DEZ}-ten Abtastzeitpunkt aller Abtastzeitpunkte k_{0·}Tₐ₀ des Eingangssignals y_{DEZ}(k₀·Tₐ₀) aktiviert ist.

Parallel zum ersten Dezimations-Filter F_{DEZ}' wird in einer Einheit zur Steuersignal-Erzeugung St₀ ein Steuersignal x_{FSDEZ}(k_{0·}Tₐ₀) eingelesen, das im Fall eines gültigen Signalabschnitts des Eingangssignals x_{DEZ}(k₀·Tₐ₀) des ersten Dezimations-Filters F_{DEZ}' aktiviert ist (Signalpegel: "1") und im Fall eines ungültigen Signalabschnitts des Eingangssignals x_{DEZ}(k₀·Tₐ₀) des ersten Dezimations-Filters F_{DEZ}' deaktiviert ist (Signalpegel: "0"). Die Einheit zur Steuersignal-Erzeugung St₀ erzeugt aus dem Steuersignal x_{FSDEZ}(k₀·Tₐ₀) am Eingang ein Steuersignal y_{FSDEZ}(k₀·Tₐ₀) am Ausgang, das analog zum Einschwingvorgang des nicht dezimierenden Filters F_{DEZ} einen Einschwingvorgang in Höhe von insgesamt L_{DEZ}-1 Abtastzeitpunkten gegenüber der Anregung durch das Steuersignal x_{FSDEZ}(k₀·Tₐ₀) am Eingang aufweist. Anschließend wird das Steuersignal y_{FSDEZ}(k₀·Tₐ₀) analog zum Polyphasendezimator P_{DEZ} im Signalpfad der digitalen Filterkaskade in einem Polyphasendezimator P_{DEZ}' in ein Steuersignal Y_{FSDEZ}(k₁·Tₙ₁) mit einer um den Dezimationsfaktor R_{DEZ} gegenüber der Abtastfrequenz fₐ₀ reduzierten Abtastfrequenz fₐ₁ umgesetzt, das nach jedem i·R_{DEZ}+P_{DEZ}-ten Abtastzeitpunkt aller Abtastzeitpunkte k₀·Tₐ₀ des Steuersignals y_{FSDEZ}(k₀·Tₐ₀) aktiviert ist.

Das Ausgangssignal y_{DEZ}(k₁·Tₐ₁) des Polyphasendezimators P_{DEZ} wird einer Betragsbildung unterworfen und anschließend einem zweiten Dezimations-Filter F_{M}' zugeführt. Dieses zweite Dezimations-Filter F_{M}' faltet das Eingangssignal x_{M}(k₁·Tₐ₁) in seinem nicht dezimierenden FIR-Filter F_{M} mit dessen Impulsantwort h_{M}(k₁·Tₐ₁) und erzeugt ein Ausgangssignal y_{M}(k₁·Tₐ₁) mit einem Einschwingvorgang in Höhe von insgesamt L_{M}-1 Abtastzeitpunkten seit Anregung des FIR-Filters F_{M} mit dem Eingangssignal x_{M}(k₁·Tₐ₁). Anschließend wird das Ausgangssignal y_{M}(k₁·Tₐ₁) mit einem Polyhasen-Dezimator P_{M} in ein Ausgangssignal y_{M}(k₂·Tₐ₂) gewandelt, das eine um den Dezimationsfaktor R_{M} reduzierte Abtastfrequenz fₐ₂ gegenüber der Abtastfrequenz fₐ₁ des Eingangssignals x_{M}(k₁·Tₐ₁) umgesetzt, das nach jedem i·R_{M}+p_{M}-ten Abtastzeitpunkt aller Abtastzeitpunkte k₁·Tₐ₁ des Eingangssignals y_{M}(k₁·Tₐ₁) aktiviert ist.

Parallel zum zweiten Dezimations-Filter F_{M}' wird in einer Einheit zur Steuersignal-Erzeugung St₁ das Steuersignal x_{FSM}(k₁·Tₐ₁) eingelesen, das dem vom vom Polyphasendezimator erzeugten Steuersignal y_{FSM}(k₁·Tₐ₁) entspricht. Der Einheit zur Steuersignal-Erzeugung St₁ erzeugt aus dem Steuersignal x_{FSM}(k₁·Tₐ₁) am Eingang ein Steuersignal y_{FSM}(k₁·Tₐ₁) am Ausgang, das analog zum Einschwingvorgang des nicht dezimierenden Filters F_{M} einen Einschwingvorgang in Höhe von insgesamt L_{M}-1 Abtastzeitpunkten gegenüber der Anregung durch das Steuersignal x_{FSM}(k₁·Tₐ₁) aufweist. Anschließend wird das Steuersignal y_{FSM}(k₁·Tₐ₁) analog zum Polyphasendezimator P_{M} im Signalpfad der digitalen Filterkaskade in einem Polyphasendezimator P_{M}' in ein Steuersignal y_{FSM}(k₂·Tₐ₂) mit einer um den Dezimationsfaktor R_{M} gegenüber der Abtastfrequenz fₐ₁ reduzierten Abtastfrequenz fₐ₂ umgesetzt, das nach jedem i·R_{M}+p_{M}-ten Abtastzeitpunkt aller Abtastzeitpunkte k₁·Tₐ₁ des Steuersignals y_{FSM}(k₁·Tₐ₁) aktiviert ist.

Das Ausgangssignal y_{IIR}(k₂·Tₐ₂) des Polyphasendezimators P_{M} stellt das Eingangssignal x_{IIR}(k₂·Tₐ₂) des IIR-Filters F_{IIR} dar, das mit der Impulsantwort h_{IIR}(k₂·Tₐ₂) des IIR-Filters F_{IIR} gewichtet wird und zum Ausgangssignal y_{IIR}(k₂·Tₐ₂) führt. Das Ausgangssignal y_{IIR}(k₂·_{Ta2}) des IIR-Filters F_{IIR} wird abschließend einer Betrags- und Leistungsmittelung unterworfen.

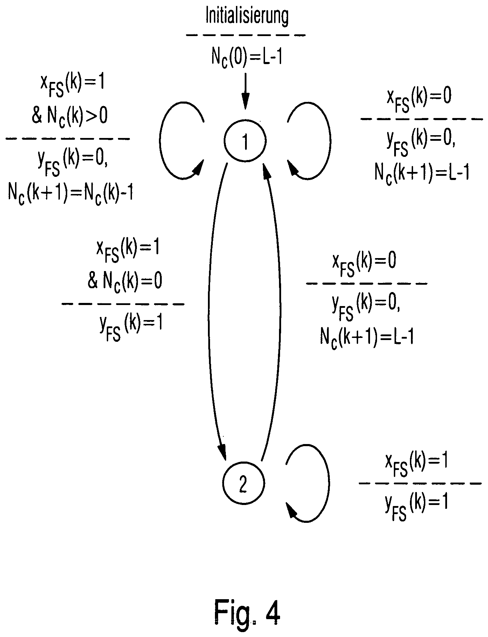

Die Funktionsweise der beiden Einheiten zur Steuersignal-Erzeugung St₀ und St₁ werden anhand des Zustandsdiagramms in Fig. 4 beschrieben. Zu Beginn der Messungen des Spektrumanalysators werden die zu den Einheiten zur Steuersignal-Erzeugung St₀ und St₁ jeweils gehörigen Zähler mit dem Zählerstand L_{DEZ}-1 bzw. L_{M}-1 initialisiert. Sobald das Steuersignal x_{FSDEZ}(k₀·Tₐ₀) bzw. x_{FSM}(k₁·Tₐ₁) am Eingang der Einheit zur Steuersignal-Erzeugung St₀ bzw. St₁ aktiviert ist - gültiger Signalabschnitt des Eingangssignals x_{DEZ}(k₀·Tₐ₀) bzw. x_{M}(k₁·Tₐ₁) -, wird der jeweilige Zähler der Einheit zur Steuersignal-Erzeugung St₀ bzw. St₁ im Takt der Abtastfrequenz fₐ₀ bzw. fₐ₁ dekrementiert. Solange der jeweilige Zähler dekrementiert wird, erzeugt die jeweilige Einheit zur Steuersignal-Erzeugung St₀ bzw. St₁ an ihrem Ausgang jeweils ein deaktiviertes Steuersignal y_{FSDEZ}(k₀·Tₐ₀) bzw. y_{FSM}(k₁·Tₐ₁) (Signalpegel: "0"). Sobald der jeweilige Zähler den Zählerstand 0 ereicht hat - Einschwingvorgang der nicht dezimierenden Filter F_{DEZ} und F_{M} beendet - wird das jeweilige Steuersignal y_{FSDEZ}(k₀·Tₐ₀) bzw. y_{FSM}(k₁·Tₐ₁) aktiviert (Signalpegel: "1").

Das jeweilige Steuersignal y_{FSDEZ}(k₀·Tₐ₀) bzw. y_{FSM}(k₁·Tₐ₁) bleibt solange aktiviert, bis das jeweilige Steuersignal x_{FSDEZ}(k₀·Tₐ₀) bzw. x_{FSM}(k₁·Tₐ₁) am Eingang aktiviert ist (gültiger Signalabschnitt des Eingangssignals x_{DEZ}(k₀·Tₐ₀) bzw. x_{M}(k₁·Tₐ₁)). Liegt kein gültiger Signalabschnitt des Eingangssignals x_{DEZ}(k₀·Tₐ₀) bzw. x_{M}(k₁·Tₐ₁) mehr vor, so werden die jeweilige Steuersignale x_{FSDEZ}(k₀·Tₐ₀) bzw. x_{FSM}(k₁·Tₐ₁) am Eingang der jeweiligen Einheit zur Steuersignal-Erzeugung St₀ bzw. St₁ deaktiviert und zeitgleich auch die Steuersignale y_{FSDEZ}(k₀·Tₐ₀) bzw. y_{FSM}(k₁·Tₐ₁) am Ausgang (ungültiger Signalabschnitt des Eingangssignals x_{DEZ}(k₀·Tₐ₀) bzw. x_{M}(k₁·Tₐ₁)). Die Steuersignale y_{FSDEZ}(k₀·Tₐ₀) bzw. y_{FSM}(k₁·Tₐ₁) am Ausgang der jeweiligen Einheit zur Steuersignal-Erzeugung St₀ bzw. St₁ bleiben solange deaktiviert, bis die jeweilige Steuersignale x_{FSDEZ}(k₀·Tₐ₀) bzw. x_{FSM}(k₁·Tₐ₁) am Eingang der jeweiligen Einheit zur Steuersignal-Erzeugung St₀ bzw. St₁ wieder aktiviert werden und der jeweilige Zähler von neuem mit dem Zählerstand L_{DEZ}-1 bzw. L_{M}-1 initialisiert wird und dekrementiert wird, bis im eingeschwungenen Zustand der Wert Null erreicht ist.

Liegt ein deaktiviertes Steuersignal x_{FSM}(k₁·Tₐ₁) am Eingang der Einheit zur Steuersignal-Erzeugung St₁ an, so wird gemäß Fig. 3 über die Signalleitung SL₁ der Filterzustand des nicht dezimierenden Filters F_{M} angehalten und "eingefroren". Liegt analog ein deaktiviertes Steuersignal y_{FSM}(k₁·Tₐ₁) am Ausgang der Einheit zur Steuersignal-Erzeugung St₁ an, so wird gemäß Fig. 3 über die Signalleitung SL₂ der Filterzustand des Polyphasendezimators P_{M} angehalten und "eingefroren". Liegt schließlich analog ein deaktiviertes Steuersignal y_{FSM}(k₂·Tₐ₂) am Ausgang des Polyphasendezimators P_{M}' an, so werden gemäß Fig. 3 über die Signalleitung SL₃ der Filterzustand des nicht dezimierenden Filters F_{IIR} angehalten und "eingefroren".

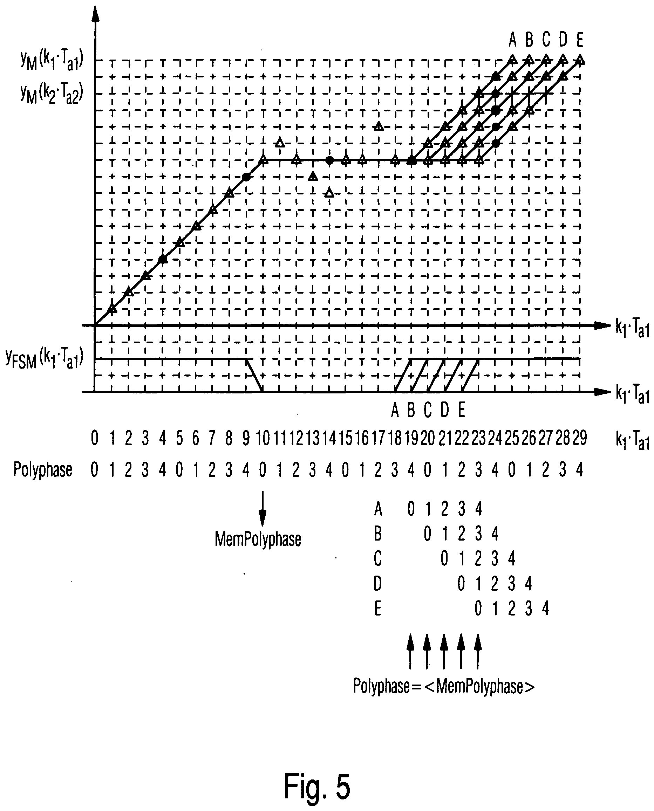

In Fig. 5 ist das "Einfrieren" des Filterzustand eines digitalen Einzelfilters der erfindungsgemäßen digitalen Filterkaskade während des ungültigen Signalabschnitts des zugehörigen Eingangssignals am Beispiel des Polyphasendezimators P_{M} dargestellt.

Im unteren Bereich des Zeitdiagramms ist das für den Polyphasendezimators P_{M} verantwortliche Steuersignal y_{FSM}(k₁·Tₐ₁) zwischen den Abtastzeiten k₁·Tₐ₁=10 und k₁·Tₐ₁=19 (Beispiel A), k₁·Tₐ₁=20 (Beispiel B), k₁·Tₐ₁=21 (Beispiel C), k₁·Tₐ₁=22 (Beispiel D) und k₁·Tₐ₁=23 (Beispiel E) deaktiviert. Das Eingangssignal y_{M}(k₁·Tₐ₁) des Polyphasendezimators P_{M} weist den durch unausgefüllte Dreiecke gekennzeichneten Signalverlauf auf, wobei für k₁·Tₐ₁ ≥ 19 für die 5 Beispiele A, B, C, D und E aus Anschaulichkeitsgründen jeweils unterschiedliche Signalverläufe angenommen werden. Zu erkennen ist, daß zwischen den Abtastzeiten k₁·Tₐ₁=10 und k₁·Tₐ₁=19 der Signalverlauf des Eingangssignals y_{M}(k₁·Tₐ₁) nicht mehr rampenförmig verläuft, sondern entsprechend dem Steuersignal y_{FSM}(k₁·Tₐ₁) einen ungültigen Signalverlauf aufweist.

Das Ausgangssignal y_{M}(k₂·Tₐ₂) des Polyphasendezimators P_{M} ist beim Dezimationsfaktor R_{M}=5 hinsichtlich seiner Abtastfrate fₐ₂ um den Faktor 5 gegenüber der Abtastrate fₐ₁ des Eingangssignals y_{M}(k₁·Tₐ₁) reduziert und ist bei einer Polyphasenkomponente p_{M}=4 gegenüber den Abtastzeitpunkten k₁·Tₐ₁ des Eingangssignals erst nach dem jeweils i-4-ten Abtastzeitpunkt k₁·Tₐ₁ des Eingangssignals aktiviert (gepunkteter Signalverlauf in Fig. 5). In Fig. 4 ist zu erkennen, daß der Filterzustand des Polyphasendezimators P_{M} und damit der Pegel des Ausgangssignals y_{M}(k₂·Tₐ₂) des Polyphasendezimators P_{M} auf dem Pegel des Eingangssignals y_{M}(k₁·Tₐ₁) zu Beginn des ungültigen Signalabschnitts zum Abtastzeitpunkt k₁·Tₐ₁=19 gehalten wird und bis zum Ende des ungültigen Signalabschitts zum Abtastzeitpunkt k₁·Tₐ₁=19 (Beispiel A), k₁·Tₐ₁=20 (Beispiel B), k₁·Tₐ₁=21 (Beispiel C), k₁·Tₐ₁=22 (Beispiel D) und k₁·Tₐ₁=23 (Beispiel E) "eingefroren" wird.

Zeitsynchron zur Angabe der Abtastzeitpunkte k₁·Tₐ₁ ist in Fig. 5 auch der Polyphasenzählerstand Polyphase des Polyphasenzählers dargestellt, der über die Länge des Dezimationsfaktors R_{M}=5 zyklisch zwischen den Zählerständen 0 und 4 inkrementiert wird. Zu Beginn des ungültigen Signalabschnitts des Eingangssignals y_{M}(k₁·Tₐ₁) des Polyphasendezimators P_{M} bei k₁·Tₐ₁=19 wird der Polyphasenzählerstand des Polyphasenzählers Polyphase=0 in den Polyphasenspeicher Mempolyphase eingelesen und zu Beginn den nächsten gültigen Signalabschnitts k₁·Tₐ₁=19 (Beispiel A), k₁·Tₐ₁=20 (Beispiel B), k₁·Tₐ₁=21 (Beispiel C), k₁·Tₐ₁=22 (Beispiel D) und k₁·Tₐ₁=23 (Beispiel E) der Polyphasenzählerstand mit dem Inhalt Mempolyphase> des Polyphasenspeichers Mempolyphase von neuem intialisiert (Polyphase=<Mempolyphase>). Auf diese Weise ist das Ausgangssignal y_{M}(k₂·Tₐ₂) des Polyphasendezimators P_{M} jeweils nach jedem i.4-ten Abtastzeitpunkt k₁·Tₐ₁ des Eingangssignals seit Beginn des neuen gültigen Signalabschnitts des Eingangssignals y_{M}(k₁·Tₐ₁) des Polyphasendezimators P_{M} korrekterweise aktiviert. Der erste aktivierte Abtastwert des Ausgangssignals y_{M}(k₂·Tₐ₂) des Polyphasendezimators P_{M} liegt also zum Abtastzeitpunkt k₁·Tₐ₁=23 (Beispiel A), k₁·Tₐ₁=24 (Beispiel B), k₁·Tₐ₁=25 (Beispiel C), k₁·Tₐ₁=26 (Beispiel D) und k₁·Tₐ₁=27 (Beispiel E) vor (gekreuztes Symbol in Fig. 59). Der Polyphasendezimator P_{M} arbeitet somit im Anschluss an den ungültigen Signalabschnitt phasenkorrekt wie im Falle eines Nichtauftretens des ungültigen Signalabschnitts weiter.

Bis zum Beginn des ersten gültigen Signalabschnitts des Eingangssignals y_{M}(k₁·Tₐ₁) des Polyphasendezimators P_{M} wird der Polyphasenspeicher mit dem Wert 0 initialisiert, der dann zum Zeitpunkt des Beginns des ersten gültigen Signalabschnitts des Eingangssignals y_{M}(k₁·Tₐ₁) des Polyphasendezimators P_{M} in den Polyphasenzähler übertragen wird und eine phasenkorrekte Ausgabe der Abtastwerte des Polyphasendezimators P_{M} ab dem Beginn des ersten gültigen Signalabschnitts des Eingangssignals y_{M}(k₁·Tₐ₁) des Polyphasendezimators P_{M} ermöglicht.

Bei einem Übergang von einem gültigen Zustand in einen ungültigen Zustand muss der zuletzt gültige Zustand bis zum nächsten gültigen Zustand beibehalten werden. Der letzte gültige Zustand kann auch zwischengespeichert werden und später bei Erreichen des nächsten gültigen Zustands reinitialisiert werden.

Die Erfindung ist nicht auf die dargestellte Ausführungsform beschränkt. Von der Erfindung sind auch digitale Filterkaskaden mit mehreren seriell und/oder parallel verschalteten dezimierenden und/oder nicht dezimierenden Filtern abgedeckt.

## Patentansprüche

1. Digitale Filterkaskade bestehend aus mindestens einem ersten digitalen Filter (F_{DEZ}') mit jeweils höherer Bandbreite und mindestens einem zweiten aus zwei kaskadierten Filtern bestehenden digitalen Filter (F_{M}',F_{IIR}') mit jeweils niedrigerer Bandbreite, wobei der Eingang der digitalen Filterkaskade von einem abgetasteten Eingangssignal (x_{DEZ}(k₀·Tₐ₀)) mit mehreren durch jeweils einen ungültigen Signalabschnitt voneinander getrennten gültigen Signalabschnitten beaufschlagt wird,
**dadurch gekennzeichnet,**
**dass** die Filterzustände jedes zweiten digitalen Filters (F_{M}', F_{IIR}') mit niedriger Bandbreite zu Beginn des jeweils ungültigen Signalabschnitts seines Eingangssignals (x_{M}(k₁·Tₐ₁), X_{IIR}(k₂·Tₐ₂)) über die gesamte Dauer des jeweiligen ungültigen Signalabschnitts unverändert bleiben, so dass am Ausgang jedes zweiten digitalen Filters (F_{M}', F_{IIR}') mit niedrigerer Bandbreite über die gesamte Dauer des jeweils ungültigen Signalabschnitts seines Eingangssignals der vor dem Beginn des jeweils ungültigen Signalabschnitts seines Eingangsignals erzeugte Ausgangswert anliegt und, dass eine zum jeweils vorausgehenden digitalen Filter (F_{DEZ}', F_{M}') gehörige Einheit zur Steuersignal-Erzeugung (St₀, St₁) ein Steuersignal (y_{FSDEZ}(k₁·Tₐ₁), y_{FSM}(k₂·Ta₂)) erzeugt, das dem jeweils nachfolgenden digitalen Filter (F_{M}', F_{IIR}') signalisiert, ob das zum jeweils nachfolgenden digitalen Filter (F_{M}', F_{IIR}') gehörige Eingangssignal (x_{M}(k₁·Tₐ₁), x_{IIR}(k₂·Ta2)) aktuell einen gültigen oder einen ungültigen Signalabschnitt aufweist, wobei ein externes Steuersignal der zum ersten digitalen Filter zugehörigen Einheit zur Steuersignal-Erzeugung zugeführt wird.

2. Digitale Filterkaskade nach Anspruch 1,
**dadurch gekennzeichnet,**
**dass** das externes Steuersignal (x_{FSDEZ}(k₀·Tₐ₀)) dem ersten digitalen Filter (F_{DEZ}') signalisiert, ob das zum ersten digitalen Filter (F_{DEZ}') gehörige Eingangssignal (x_{DEZ}(k₀·Tₐ₀)) aktuell einen gültigen oder ungültigen Signalabschnitt aufweist.

3. Digitale Filterkaskade nach einem der Ansprüche 1 oder 2, **dadurch gekennzeichnet,**
**dass** das erste und eines des zweiten digitale Filter (F_{DEZ}',F_{M}') jeweils ein dezimierendes Filter (F_{DEZ}', F_{M}') mit zumindest einen Polyphasendezimator (P_{DEZ},P_{M}) mit einem Dezimationsfaktor (R_{DEZ},R_{M})) und einer Polyphasenkomponente (p_{DEZ},p_{M}) sind.

4. Digitale Filterkaskade nach Anspruch 3, **dadurch gekennzeichnet,**
**dass** ein im Polyphasendezimator (P_{DEZ},P_{M}) des jeweiligen dezimierenden Filters (F_{DEZ}',F_{M}') enthaltener Polyphasenzähler, der über die Länge des zugehörigen Dezimationsfaktors (R_{DEZ},R_{M}) mit der Abtastrate (fₐ₀,fₐ₁) des zugehörigen Eingangssignals (x_{DEZ}(k₁·Tₐ₁),x_{M}(k₂·Tₐ₂)) inkrementiert, den zu Beginn des jeweils ungültigen Signalabschnitts vorliegenden Polyphasenzählerstand (Polyphase) in einem Polyphasenspeicher (MemPolyphase) ablegt.

5. Digitale Filterkaskade nach Anspruch 4, **dadurch gekennzeichnet,**
**dass** am Ende des jeweils ungültigen Signalabschnitts der Polyphasenzählerstand (Polyphase) mit dem im Polyphasenspeicher (Mempolyphase) abgelegten Inhalt (<Mempolyphase>) aktualisiert ist, der dem Polyphasenzählerstand (Polyphase) zu Beginn des jeweils ungültigen Signalabschnitts entspricht.

6. Digitale Filterkaskade nach Anspruch 4 oder 5, **dadurch gekennzeichnet,**
**dass** spätestens zu Beginn des ersten gültigen Signalabschnitts des zum jeweiligen dezimierenden Filter (F_{DEZ}', F_{M}') gehörigen Eingangssignals (x_{DEZ}(k₁·Tₐ₁), x_{M}(k₂·Tₐ₂)) der Polyphasenspeicher (Mempolyphase) und der Polyphasenzählerstand (Polyphase) des zum jeweiligen dezimierenden Filter (F_{DEZ}', F_{M}') gehörigen Polyphasendezimators (P_{DEZ},P_{M}) mit dem Wert 0 belegt ist.

## Claims

1. Digital filter cascade consisting of at least one first digital filter (F_{DEZ}') with in each case a higher band width and at least one second digital filter (F_{M}', F_{IIR}') consisting of two cascaded filters with in each case a lower band width, wherein the input of the digital filter cascade is supplied with a sampled input signal (x_{DEZ}(k_{0·}Tₐ₀)) with a plurality of valid signal portions separated from one another by in each case an invalid signal portion,
**characterised in that**
the filter states of each second digital filter (F_{M}', F_{IIR}') with a low band width at the beginning of each invalid signal portion of its input signal (x_{M} (k₁.Tₐ₁), x_{IIR}(k₂.Tₐ₂)) remain unchanged over the entire duration of the respective invalid signal portion so that the output value produced before the beginning of each invalid signal portion of its input signal is present at the output of each second digital filter (F_{M}', F_{IIR}') with a lower band width over the entire duration of each invalid signal portion of its input signal and
**in that** a unit for producing a control signal (St₀, St₁) associated with the in each case preceding digital filter (F_{DEZ}', F_{M}') produces a control signal (y_{FSDEZ}(k₁.Ta₁), y_{FSM} (k₂.Tₐ₂)) which signals to the in each case following digital filter (F_{M}', F_{IIR}') whether the input signal (x_{M}(k₁.Tₐ₁), x_{IIR}(k₂.Tₐ₂)) associated with the in each case following digital filter (F_{M}', F_{IIR}') currently has a valid or an invalid signal portion, wherein an external control signal of the unit associated with the first digital filter is used to produce the control signal.

2. Digital filter cascade according to claim 1,
**characterised in that**
the external control signal (x_{FSDEZ}(k₀.Tₐ₀)) signals to the first digital filter (F_{DEZ}') whether the input signal (x_{DEZ}(k₀.Tₐ₀)) associated with the first digital filter (F_{DEZ}') currently has a valid or an invalid signal portion.

3. Digital filter cascade according to one of claims 1 or 2,
**characterised in that**
the first and one of the second digital filters (F_{DEZ}', F_{M}') are in each case a decimating filter (F_{DEZ}', F_{M}') with at least one polyphase decimator (P_{DEZ}, P_{M}) with a decimation factor (R_{DEZ}, R_{M}) and a polyphase component (p_{DEZ}, p_{M}).

4. Digital filter cascade according to claim 3,
**characterised in that**
a polyphase counter which is contained in the polyphase decimator (P_{DEZ}, P_{M}) of the respective decimating filter (F_{DEZ}', F_{M}') and increments over the length of the associated decimation factor (R_{DEZ}, R_{M}) with the sampling rate (fₐ₀, fₐ₁) of the associated input signal (x_{DEZ}(k₁.Tₐ₁), x_{M}(k₂.Tₐ₂)) stores the polyphase counter state (Polyphase) present at the beginning of each invalid signal portion in a polyphase memory (MemPolyphase).

5. Digital filter cascade according to claim 4,
**characterised in that**
at the end of each invalid signal portion the polyphase counter state (Polyphase) is updated with the content (<Mempolyphase>) which is stored in the polyphase memory (Mempolyphase) and which corresponds to the polyphase counter state (Polyphase) at the beginning of each invalid signal portion.

6. Digital filter cascade according to claim 4 or 5,
**characterised in that**
at the latest at the beginning of the first valid signal portion of the input signal (x_{DEZ} (k₁.Tₐ₁), x_{M}(k₂.Tₐ₂)) associated with the respective decimating filter (F_{DEZ}', F_{M}') the polyphase memory (Mempolyphase) and the polyphase counter state (Polyphase) of the polyphase decimator (P_{DEZ}, P_{M}) associated with the respective decimating filter (F_{DEZ}', F_{M}') is given the value 0.

## Revendications

1. Cascade de filtres numériques constituée d'au moins un premier filtre numérique (F_{DEZ}') de largeur de bande supérieure et d'au moins un deuxième filtre numérique (F_{M}', F_{IIR}') de largeur de bande inférieure comprenant deux filtres en cascade, dans laquelle l'entrée de la cascade de filtres numériques est soumise à un signal d'entrée balayé (X_{DEZ}(k₀·Tₐ₀)) comportant plusieurs sections de signal valides séparées l'une de l'autre par une section de signal invalide,
**caractérisée**
**en ce que** les états de filtre de chaque deuxième filtre numérique (F_{M}', F_{IIR}') de largeur de bande inférieure au commencement de la section de signal invalide respective de son signal d'entrée (X_{M}(k₁·Tₐ₁), X_{IIR}(k₂·Tₐ₂)) restent inchangés pendant toute la durée de la section de signal invalide respective, si bien qu'à la sortie de chaque deuxième filtre numérique (F_{M}', F_{IIR}') de largeur de bande inférieure, la valeur générée avant le commencement de la section de signal invalide respective de son entrée de signal est appliquée pendant toute la durée de la section de signal invalide respective de son signal d'entrée, et
**en ce qu'**une unité de génération de signal de commande (St₀, St₁) relevant du filtre numérique (F_{DEZ}', F_{M}') respectif en amont génère un signal de commande (y_{FSDEZ}(k₁·Tₐ₁), y_{FSM}(k₂·Tₐ₂)) signalant au filtre numérique (F_{M}', F_{IIR}') respectif en aval si le signal d'entrée (X_{M}(k₁·Tₐ₁), X_{IIR}(k₂·Tₐ₂)) relevant du filtre numérique (F_{M}', F_{IIR}') respectif en aval présente actuellement une section de signal valide ou invalide, dans laquelle un signal de commande externe est acheminé vers l'unité de génération de signal de commande relevant du premier filtre numérique.

2. Cascade de filtres numériques selon la revendication 1,
**caractérisée**
**en ce que** le signal de commande externe (X_{FSDEZ}(k₀·Tₐ₀)) signal au premier filtre numérique (F_{DEZ}') si le signal d'entrée (X_{DEZ}(k₀·Tₐ₀)) relevant du premier filtre numérique (F_{DEZ}') présente actuellement une section de signal valide ou invalide.

3. Cascade de filtres numériques selon la revendication 1 ou 2,
**caractérisée**
**en ce que** le premier, et un des deuxièmes filtres numériques (F_{DEZ}', F_{M}') sont chacun un filtre de décimation (F_{DEZ}', F_{M}') comportant au moins un décimateur polyphasé (P_{DEZ}, P_{M}) avec un facteur de décimation (R_{DEZ}, R_{M})) et une composante polyphase (p_{DEZ}, p_{M}).

4. Cascade de filtres numériques selon la revendication 3,
**caractérisée**
**en ce qu'**un compteur polyphasé contenu dans le décimateur polyphasé (P_{DEZ}, P_{M}) du filtre de décimation (F_{DEZ}', F_{M}') respectif, lequel incrémente sur la longueur du facteur de décimation (R_{DEZ}, R_{M}) correspondant la fréquence de balayage (fₐ₀, fa1) du signal d'entrée (X_{DEZ}(k₁·Tₐ₁), X_{M}(k₂·Tₐ₂)) correspondant, sauvegarde dans une mémoire polyphase (MemPolyphase) l'état de compteur polyphasé (Polyphase) présenté au commencement de la section de signal invalide respective.

5. Cascade de filtres numériques selon la revendication 4,
**caractérisée**
**en ce qu'**à la fin de la section de signal invalide respective, l'état de compteur polyphasé (Polyphase) est actualisé avec le contenu (<Mempolyphase>) sauvegardé dans la mémoire polyphase (Mempolyphase), lequel correspond à l'état de compteur polyphasé (Polyphase) au commencement de la section de signal invalide respective.

6. Cascade de filtres numériques selon la revendication 4 ou 5,
**caractérisée**
**en ce qu'**au plus tard au commencement de la première section de signal valide du signal d'entrée (X_{DEZ}(k₁·Tₐ₁), X_{M}(k₂·Tₐ₂)) relevant du filtre de décimation (F_{DEZ}', F_{M}') respectif, la valeur 0 est affectée à la mémoire polyphase (Mempolyphase) et à l'état de compteur polyphasé (Polyphase) du décimateur polyphasé (P_{DEZ}, P_{M}) relevant du filtre de décimation (F_{DEZ}', F_{M}') respectif.
